# FASCICULE DE BREVET EUROPEEN

(11) **EP 2 992 545 B1**
(45) Date de publication et mention de la délivrance du brevet: **02.12.2020**
(21) Numéro de dépôt: 14725211.8
(22) Date de dépôt: 17.04.2014
(51) Int. Cl.: H01J 37/302, H01J 37/317

(54) **PROCÉDÉ DE LITHOGRAPHIE À OPTIMISATION COMBINÉE DE L'ÉNERGIE RAYONNÉE ET DE LA GÉOMÉTRIE APPLICABLE SUR DES FORMES COMPLEXES**
VERFAHREN ZUR LITHOGRAFIE MIT KOMBINIERTER OPTIMIERUNG DER AN KOMPLEXE FORMEN ABGESTRAHLTEN ENERGIE UND DER AN KOMPLEXE FORMEN ANWENDBAREN GEOMETRIE
METHOD OF LITHOGRAPHY WITH COMBINED OPTIMIZATION OF THE ENERGY RADIATED AND OF THE GEOMETRY APPLICABLE TO COMPLEX SHAPES

(30) Priorité: 29.04.2013 FR 1300997
(43) Date de publication de la demande: 09.03.2016
(73) Titulaire: Aselta Nanographics, 38000 Grenoble (FR)
(72) Inventeur: TIPHINE, Charles, F-38130 Echirolles (FR); BAYLE, Sébastien, F-38600 Fontaine (FR)
(74) Mandataire: Talbot, Alexandre
(86) Numéro de dépôt international: PCT/FR2014/000086
(87) Numéro de publication internationale: WO 2014/177776

(56) Documents cités:
- US-A- 5 698 859
- US-A1- 2002 177 056
- US-A1- 2003 152 850
- US-A1- 2004 044 984

## Description

### Domaine technique de l'invention

L'invention concerne un procédé de génération de données relatives à la fabrication d'un motif par insolation à partir d'un rayonnement électronique et un procédé de fabrication d'un motif par insolation à partir d'un rayonnement électronique.

### État de la technique

Dans le domaine des circuits intégrés, les systèmes d'écriture par canons à électrons sont utilisés couramment pour définir des motifs ayant des dimensions faibles.

Dans ces systèmes d'écriture, des particules chargées électriquement sont projetées sur la surface d'une couche, communément appelée résine. Le rayonnement électronique entraine la réaction d'une partie de la couche de résine pour définir deux matériaux ayant des propriétés physico-chimiques différentes. Ces différences de propriété sont utilisées dans une étape postérieure de développement ce qui permet de former un ou plusieurs motifs.

Les conditions d'insolation appliquées permettent de définir les formes et les positions des différents motifs. Cependant, afin de transformer le matériau formant la couche réactive en un autre matériau présentant des propriétés physico-chimiques différentes, il faut qu'une quantité suffisante d'électrons transmettent leur énergie dans la couche. Or, il existe en pratique des phénomènes inévitables de diffusion des électrons (diffraction du faisceau incident, différents mécanismes de diffusion à l'intérieur de la résine et des matériaux adjacents, une partie des électrons ressort de la résine et une partie des électrons qui sont ressorties reviennent dans la résine après une réflexion sur un élément extérieur ou après diffusion vers l'arrière depuis le substrat). Ces phénomènes de diffusion font que l'énergie envoyée dans la résine n'est pas reliée simplement à la forme du faisceau d'électrons incident. Il y a donc un choix judicieux à réaliser dans les conditions d'insolation et de développement pour que les motifs formés soient le plus conformes possibles à ce qui est attendu.

Dans les modes de réalisation appelés insolation par trame (ou raster scanning) et « Vector Scan », le faisceau d'électrons se déplace par rapport à la couche réactive de manière à définir un ou plusieurs motifs qui vont former le dessin final. Dans un autre mode de réalisation appelé « Variable Shaped Beam », le faisceau est projeté à travers une ou plusieurs ouvertures qui sont agencées pour définir le motif recherché. Classiquement, les différentes parties de chaque motif sont obtenues à partir de l'utilisation de plusieurs tirs de canon à électrons (plusieurs shots).

La forme du motif à réaliser est décomposée en une pluralité de dessins élémentaires. Ces différents dessins élémentaires sont ensuite analysés afin de définir les conditions d'insolation par le faisceau d'électrons. De cette manière, le motif initial est décomposé en une pluralité de tirs de canon à électrons qui sont représentatifs du dessin élémentaire associé.

Comme il n'est pas facile de modifier totalement la forme du faisceau d'électrons, ni de maîtriser la diffusion des électrons à l'intérieur de la couche réactive, il n'est pas possible de réaliser directement toutes les formes présentes dans le motif. Dans la pratique, les équipements générant le rayonnement électronique ont un jeu réduit de shots possibles et ils ont également des tailles limitées.

Les effets de proximité, notamment entre les motifs voisins, se traduisent en général par une différence notable de forme entre le motif obtenu et le motif recherché initialement. Pour accroitre la fidélité entre motif final par rapport à ce qui est demandé, différentes stratégies sont développées.

Dans le document US 6,107,207, la dose appliquée sur les bords du motif est augmentée ce qui se traduit par une augmentation conséquente du temps d'exposition. Dans ce cas de figure, la forme définie par les dessins élémentaires est identique à la forme du motif à réaliser.

Dans le document FR 2 959 026, une méthode d'optimisation combinée de l'énergie du rayonnement électronique appliqué et de la zone d'application est proposée. Un motif à réaliser est fracturé en éléments unitaires et des modulations de doses rayonnées (shots) sont calculées pour chaque élément unitaire. Les formes des éléments unitaires sont modifiées en rajoutant une bande latérale de manière à ce que la dose rayonnée permette la définition d'un motif final qui soit fidèle à la forme du motif recherché.

US2004/044984A1 (KEOGAN DANNY [US] ET AL) 4 mars 2004 (2004-03-04) divulgue de considérer des propriétés de l'enregistreur de masques durant la correction des effets de proximité optique.

### Objet de l'invention

On constate qu'il existe un besoin de prévoir un procédé de génération de données relatives à la formation d'un motif qui diminue l'écart de forme entre le motif recherché et le motif obtenu après insolation par le faisceau d'électrons.

On tend à combler ce besoin au moyen d'un procédé selon la revendication indépendante 1.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 représente, un organigramme des différentes étapes du procédé de réalisation d'un motif recherché,
- les figures 2 à 6 représentent, de manière schématique, le motif à réaliser, le motif de travail, les dessins élémentaires et les motifs simulés au cours des différentes étapes du procédé.

### Description de modes de réalisation préférentiels de l'invention

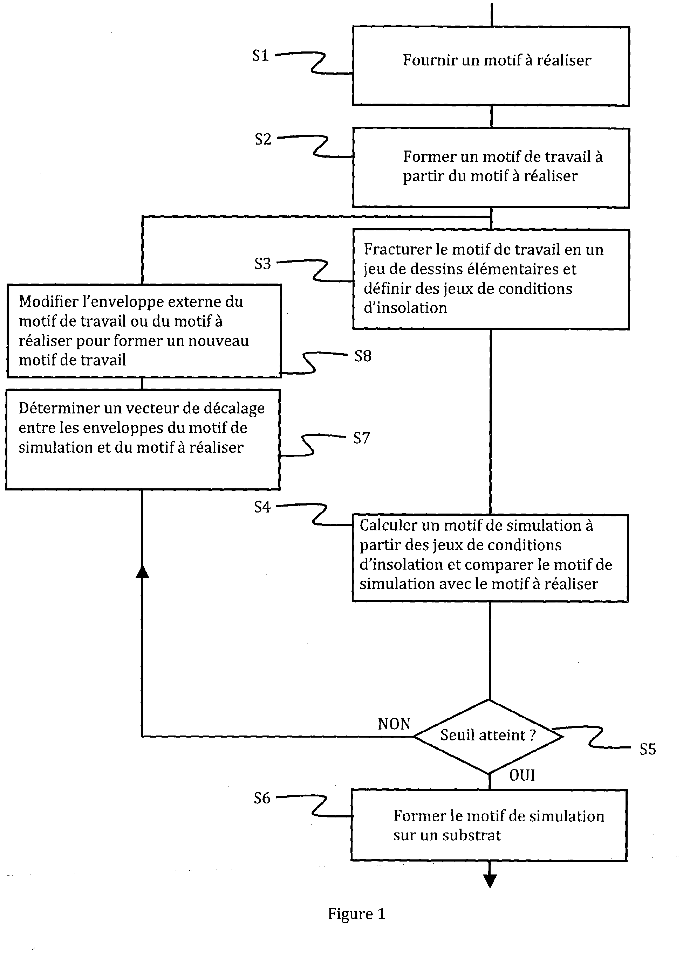

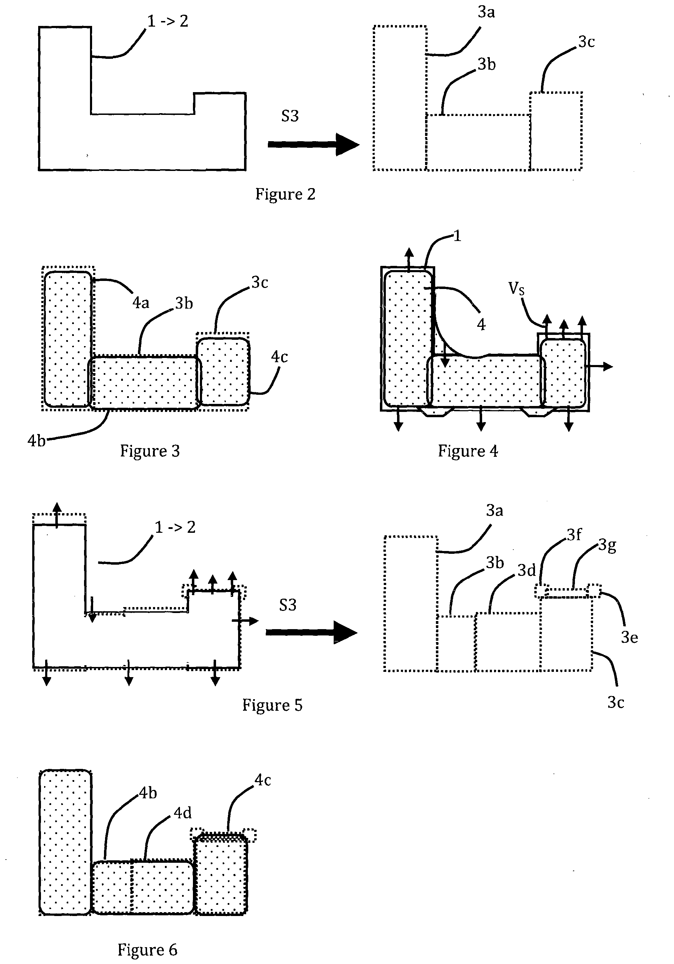

Comme illustré aux figures 1 et 2, un motif à réaliser 1 est fourni pour être formé sur un substrat. A une étape S1, un premier motif 1 est fourni et il correspond au motif que l'utilisateur recherche, c'est-à-dire le motif à réaliser 1. Le motif à réaliser 1 est défini par une forme, c'est-à-dire une configuration dans le plan associée et une aire (une surface). Ces deux caractéristiques sont simultanément représentées par le contour extérieur du motif, c'est-à-dire l'enveloppe externe qui définit le motif 1. Ces composantes permettent de caractériser et différencier les motifs entre eux. Le motif à réaliser 1 peut être de forme quelconque, un carré, un rectangle, un cercle ou une forme libre. Le motif à réaliser peut avoir un ou plusieurs trous.

Le motif à réaliser 1 est défini par une enveloppe externe qui est continue et fermée. Le motif à réaliser 1 est donc un motif unique. Il n'est pas défini par un ensemble de motifs élémentaires distincts les uns les autres. Le motif à réaliser 1 peut être représentatif, par exemple, d'une électrode de grille, d'une zone active à l'intérieur de laquelle des électrodes de source et de drain seront définies, un contact électrique ou n'importe quel autre élément d'un circuit intégré. Il est également possible d'utiliser le procédé pour d'autres applications.

Le substrat est quelconque, il peut être électriquement conducteur ou isolant. Le substrat peut être un substrat semi-conducteur ou un substrat transparent qui va servir, par la suite, de masque de photolithographie. Le substrat comporte une couche réactive qui est configurée pour réagir avec le rayonnement électronique, par exemple une résine.

Dans une deuxième étape S2, le motif à réaliser 1 est utilisé pour former un motif de travail 2. De manière avantageuse, le motif de travail 2 correspond exactement au motif à réaliser 1. Cependant, il est envisageable de légèrement modifier le motif à réaliser 1 pour former le motif de travail 2. Par exemple, certaines formes sont éliminées car elles ont une dimension inférieure aux capacités techniques de la résine et/ou du faisceau électronique. Cette simplification du motif de travail 2 (par rapport au motif à réaliser 1) permet de réduire les temps de calcul.

Dans une étape S3, le motif de travail 2 est fracturé en un jeu de dessins élémentaires 3. A titre d'exemple, le motif de travail 2 est décomposé en trois dessins élémentaires 3a, 3b et 3c.

Lors de la fracturation S3, comme illustrée à la figure 2, le motif de travail 2 est décomposé en une pluralité de dessins élémentaires 3 qui ont avantageusement des formes standardisées. Avantageusement, les motifs élémentaires sont des motifs économes en mémoire et/ou qui permettent de réduire la durée de l'étape de fracturation. De préférence, les dessins élémentaires 3 ont des formes simples. Dans un mode de réalisation particulier, les dessins élémentaires sont des polyèdres convexes ayant au plus quatre côté. Par exemple, les dessins élémentaires 3 sont des carrés et des rectangles. La forme des dessins élémentaires 3 peut être imposée par les capacités techniques de l'équipement produisant le rayonnement électronique. Cependant, dans une variante de réalisation, les dessins élémentaires 3 peuvent présenter un contour curviligne. Avantageusement, les formes des différents dessins élémentaires sont définies par l'équipement de lithographie électronique qui possède un nombre restreint de conditions d'insolation définissant les dessins accessibles. A chaque dessin élémentaire est assignée une dose qui peut comprendre un ou plusieurs shots.

Les dessins élémentaires 3 ont avantageusement une forme plus simple de manière à faciliter, par la suite, la transposition de leur forme en des caractéristiques relatives à une ou plusieurs expositions d'un rayonnement électronique. Chaque dessin élémentaire 3 est défini par sa forme (ce qui comprend la valeur de sa surface), c'est-à-dire par son enveloppe externe. Chaque dessin élémentaire 3 est également défini par sa position. Dans l'exemple illustré à la figure 2, le motif à réaliser 1 est décomposé en trois dessins élémentaires qui sont représentés par des rectangles ayant des dimensions différentes et des positions différentes.

Les dessins élémentaires 3 sont avantageusement disposés jointifs les uns des autres pour éviter la présence de zones vides, c'est-à-dire des zones non irradiées ce qui modifie très fortement la forme finale du motif. Les dessins élémentaires 3 sont avantageusement disposés jointifs les uns des autres afin d'éviter le chevauchement de deux dessins élémentaires 3 adjacents.

L'association des différents dessins élémentaires 3 forme le motif de travail 2 qui est le motif à réaliser 1 ou un motif très proche du motif à réaliser 1. Lors de la fracturation S3, les dessins élémentaires 3 sont configurés pour reproduire le plus fidèlement possible la forme de l'enveloppe externe du motif de travail 2. L'enveloppe externe des différents dessins élémentaires 3 va définir la forme du motif final qui sera réalisé par le rayonnement électronique. Il a été découvert qu'un paramètre important pour une bonne définition des motifs en lithographie électronique est la surface du motif. Cependant, le travail réalisé sur la forme du motif est complété par le travail réalisé sur la dose du motif. En donnant un poids plus important à la forme du dessin à atteindre en comparaison de ce qui est réalisé dans l'art antérieur, il est possible de réaliser un dessin plus conforme au dessin recherché.

L'utilisateur ou l'équipement appliquant le rayonnement électronique peut imposer des contraintes, tel que le nombre maximal de dessins élémentaires 3 générés lors de la fracturation. Il est également possible de fixer la surface minimale et/ou maximale occupée par un dessin élémentaire ou encore le nombre de tirs de canon à électrons maximal pour définir un dessin élémentaire. Toutes ces contraintes compliquent la formation d'un motif irradié proche du motif à réaliser 1. Par exemple, il est possible d'imposer que la dimension maximale d'un motif élémentaire est inférieure à 1µm.

Chaque dessin élémentaire 3 est représenté, par exemple, par un ou plusieurs tirs de canon à électrons (shots) avec des doses et des positions qui peuvent varier entre les tirs. En d'autres termes, les dessins élémentaires 3 sont modélisés par des conditions d'insolation électronique regroupées sous la forme de jeux de conditions d'insolation. En d'autres termes, pour former un dessin élémentaire et donc un motif, plusieurs shots sont réalisés. Ces différents shots sont représentatifs de la dose nécessaire pour la définition du dessin élémentaire.

L'utilisateur peut utiliser différentes techniques, avec des recouvrements de faisceau, des largeurs variables de faisceau, des tensions d'accélération différentes ou d'autres techniques connues pour avoir un jeu de conditions d'insolation qui se rapproche le plus possible du dessin élémentaire. En pratique un équipement d'irradiation électronique ne permet pas de varier en même temps, la tension d'accélération et le temps d'exposition. L'équipement est avantageusement configuré pour proposer différentes doses mesurées en µC/cm².

Dans un mode de réalisation particulier, la fracturation géométrique S3 du motif de travail 2 est découplée de la stratégie de répartition du rayonnement électronique à l'intérieur des dessins élémentaires 3. Comme indiqué plus haut, le motif à réaliser 1 est transformé en un motif de travail 2 et le motif de travail 2 est fracturé en une pluralité de dessins élémentaires 3. En parallèle, l'espace de travail qui comporte le motif à réaliser 1 et de manière avantageuse un groupe de motifs à réaliser est découpé en une pluralité de zones de référence. Une valeur de densité est associée à chaque zone de référence. La valeur de densité représente, par exemple, le rapport de la surface occupée par le motif ou les motifs sur la surface de la zone de référence. Une fois les différentes valeurs de densité calculées, il est possible de calculer la dose à appliquer à chaque zone de référence de manière à reproduire le plus fidèlement possible le dessin inclus dans la zone de référence. De manière avantageuse, on réalise la convolution de la densité calculée précédemment avec la densité longue portée du modèle de diffusion des électrons (également appelé fonction d'étalement par point).

La stratégie d'association des doses de rayonnement électronique à chaque zone de référence peut être réalisée par différentes techniques, par exemple avec une stratégie de type Longue Portée (ou Long Range en anglais) ou au moyen d'une stratégie décrite dans le document « Proximity effect correction calculations by the integral équation approximate solution method » J.M. Pavkovich J. Vac. Sci. Technol. B 4(1) Jan/Feb 1986. De cette manière, il est possible de réaliser simplement un premier jeu de conditions d'insolation qui est représentatif du motif à réaliser 1.

Ensuite, il est intéressant de mettre en relation les dessins élémentaires 3 définis dans l'analyse géométrique du motif à réaliser 1 et le premier jeu de conditions d'insolation associé aux zones de référence pour former le jeu de conditions d'insolation associé à chaque dessin élémentaire 3.

Dans un mode de réalisation particulièrement avantageux, l'aire de chaque dessin élémentaire 3 est inférieure à l'aire d'une zone de référence de manière à limiter les corrections sur les doses d'irradiation électronique. Cette particularité permet de faciliter la convergence du procédé.

De manière particulièrement avantageuse, la différence de dose entre deux dessins élémentaires adjacents et/ou entre deux zones de référence adjacentes est inférieure à 30% de manière à faciliter la convergence du procédé.

Les conditions de modélisation d'un dessin élémentaire 3 en un jeu de conditions d'insolation sont choisies de manière à ce que la forme du dessin élémentaire soit conservée le plus possible. Cependant, comme indiqué plus haut, les électrons configurés pour représenter le dessin élémentaire diffusent en partie à l'extérieur de l'enveloppe.

Une étape de simulation S4 d'un motif de simulation 4 est réalisée. Lors de cette étape de simulation, les différents jeux de conditions d'insolation associés aux différents dessins élémentaires 3 sont utilisés pour déterminer la forme du motif de simulation 4, c'est-à-dire le motif qui devrait être obtenu après irradiation électronique. La détermination du motif de simulation tient compte des conditions d'insolation appliquées pour former les différents motifs élémentaires 3. La détermination du motif de simulation tient également compte de la diffusion d'une partie du rayonnement électronique à l'extérieur du dessin élémentaire et qui va modifier le comportement de la résine pour les dessins élémentaires adjacents.

Comme cela est visible sur la figure 3, il existe des différences entre le modèle initial (le motif de travail) et ce qui est obtenu après simulation et qui tient compte des artéfacts de réalisation, par exemple un arrondissement des coins. Les motifs 4a, 4b et 4c représentent les motifs de simulation respectivement des motifs 3a, 3b et 3c dans le cas d'une simulation sans tenir compte des phénomènes de diffusion entre les différents dessins élémentaires.

Le motif de simulation 4 prend en compte les effets physiques de l'interaction du rayonnement électronique avec la matière, notamment la réflexion à longue portée des électrons rétrodiffusés (fogging). La définition du motif de simulation peut également prendre en compte d'autres phénomènes de dégradation liés à l'irradiation électronique et/ou à des étapes ultérieures de procédé. Par exemple, la simulation peut tenir compte des artefacts de gravure si le motif à réaliser est utilisé comme masque de gravure par la suite de manière à ce que le motif gravé soit plus fidèle à ce qui est recherché. Par exemple, la simulation permet de tenir compte d'une double irradiation qui intervient notamment à cause de la diffusion.

A titre d'exemple, pour un motif ayant des dimensions de l'ordre de 10nm, il y a une diffusion des électrons de l'ordre de 10µm. Le motif de simulation 4 est lié en partie aux conditions d'insolation associées au dessin élémentaire. Le motif de simulation 4 tient également compte des conditions d'insolation des dessins élémentaires adjacents afin de prendre en compte la diffusion des électrons comme cela est illustré à la figure 4.

Dans l'étape S4, le motif de simulation 4 est comparé au motif à réaliser 1 qui est recherché par l'utilisateur. L'étape S4 de comparaison permet de discriminer un motif de simulation 4 représentatif du motif à réaliser 1 et un motif de simulation non représentatif du motif à réaliser 1. Si le motif de simulation 4 est représentatif, il en est de même du motif de travail 2 associé et du jeu de dessins élémentaires 3.

De manière avantageuse, lors de cette comparaison, on compare notamment la forme du motif de simulation 4 par rapport à la forme du motif à réaliser 1 afin de savoir par exemple si le motif de simulation 4 est à l'intérieur du dessin du motif à réaliser 1 ou si au contraire le motif de simulation 4 déborde à l'extérieur du motif à réaliser 1.

Lors de la comparaison S4, un ou plusieurs critères sont calculés et sont comparés à un seuil dans une étape S5.

L'écart entre la forme du motif irradié 4 par rapport à la forme du motif à réaliser 1 est calculé. Différentes techniques peuvent être employées pour calculer le ou les critères qui seront comparés ensuite à un seuil. Le critère de comparaison peut tenir compte de la différence de surface entre les deux motifs ce qui donne une première information sur la différence entre les motifs. Le critère peut également tenir compte de la distance maximale qui existe entre les deux motifs.

Pour comparer le motif de simulation 4 et le motif à réaliser 1, différentes techniques sont possibles. Les aires représentatives des différences sont comparées à un seuil. Il est également possible de prendre une ou plusieurs zones repères où la distance qui sépare le motif à réaliser 1 et le motif de simulation 4 est utilisée pour définir le critère qui sera comparé au seuil. Ces différentes techniques peuvent être combinées.

Le critère représentatif de l'écart est comparé à un seuil. Si le critère est inférieur au seuil (sortie OUI de S5), le motif de simulation 4 et donc les dessins élémentaires 3 sont représentatifs du motif à réaliser 4. Dans une étape S6, les jeux de conditions d'insolation relatives au motif de travail utilisé peuvent être envoyés à un dispositif de traitement. Le dispositif de traitement peut être un dispositif de commande du canon à électrons ce qui permet de réaliser le motif 1 sur un substrat. Le dispositif de traitement peut également être un dispositif de stockage de l'information qui sera ensuite envoyée dans un dispositif de commande d'un canon à électrons.

Si le critère est supérieur au seuil (sortie NON de S5), le motif de simulation 4 n'est pas suffisamment représentatif du motif à réaliser 1 et donc les dessins élémentaires 3 ne sont pas considérés aboutis. Une nouvelle itération est réalisée avec la définition d'un nouveau motif de travail 2.

Dans l'exemple illustré à la figure 4, il y a recouvrement de plusieurs zones irradiées dans des conditions qui entraînent une modification importante de la forme du motif de simulation 4 par rapport à ce qui est attendu au moyen des dessins élémentaires 3 et des jeux de conditions d'insolation pris isolément. Dans le cas de la figure 4, ces effets de double irradiation se traduisent par une extension du motif irradié 4 au-delà de la forme du motif initial 1. Il y a également un décalage important au niveau des bords pour les motifs 3a et 3c ou le remplissage d'un coin concave.

Le motif de simulation 4 peut présenter une ou plusieurs régions qui débordent de la forme du motif à réaliser 1. Il peut exister également une ou plusieurs régions où la forme du motif de simulation est en retrait par rapport au motif à réaliser 1.

Comme les deux motifs comparés sont différents, il y a détermination d'au moins un vecteur de décalage V_{S} dans une étape S7. Le vecteur de décalage V_{S} correspond au décalage qui existe entre au moins une partie de l'enveloppe externe du motif à réaliser 1 et une partie correspondante de l'enveloppe externe du motif de simulation 4. L'enveloppe externe du motif de simulation 4 est décomposée en une pluralité de zones repères qui peuvent être des points du contour, ou des portions plus importantes de ce contour.

Pour chaque zone repère, un vecteur de décalage V_{S} est déterminé qui représente l'écart existant entre la zone repère du motif de simulation 4 et la zone repère correspondante du motif à réaliser 1. Les différents vecteurs de décalage V_{S} représentent la direction et l'amplitude des écarts entre les deux motifs. Les différents vecteurs de décalage V_{S} traduisent la répartition des décalages entre les faces et éventuellement entre différentes portions d'une même face comme illustré à la figure 4.

La zone repère contient avantageusement le milieu de la face sur laquelle, elle est située. En effet, il existe très souvent un arrondissement des bords des polyèdres et il est couteux en temps de calcul de réaliser une optimisation des conditions d'insolation pour obtenir un bord parfaitement défini. Dans la mesure où les parties actives des dessins sont majoritairement placées aux milieux des côtés, il est intéressant de favoriser une bonne reproduction du motif à réaliser en ce qui concerne le milieu de ses côtés plutôt que ses coins. Dans un mode de réalisation particulier, le procédé est configuré pour assurer le respect des dimensions dans une ou plusieurs zones privilégiées. Dans ce cas de figure, le procédé accepte des écarts dans les autres zones, par exemple pour des angles droits qui ne sont pas respectés.

Dans un premier mode de réalisation illustré à la figure 5, un nouveau motif de travail 2 est formé à partir du motif à réaliser 1 ou du motif de travail 2 dans une étape S7. Il est préférable de repartir du motif à réaliser 1 au lieu du motif de travail 2 de l'itération précédente car des caractéristiques ayant des dimensions faibles ont pu disparaître lors de l'étape de modélisation. Utiliser le motif à réaliser 1 permet de converger plus facilement vers un motif de travail 2 pertinent. Dans l'exemple suivant, le motif retravaillé est le motif à réaliser 1.

Les zones repères du motif à réaliser 1 sont déplacées au moyen d'un vecteur de déplacement V_{D} qui est défini au moins à partir du vecteur de décalage. De manière avantageuse, le vecteur de décalage V_{S} et le vecteur de déplacement V_{D} sont colinéaires. De manière encore plus avantageuse, le vecteur de décalage V_{S} et le vecteur de déplacement V_{D} sont orientés dans le même sens. Le vecteur de déplacement V_{D} est réalisé à partir du vecteur de décalage V_{S} de manière à ce que l'écart qui a été mesuré entre le motif de simulation 4 et le motif à réaliser 1 soit réduit lors de l'itération suivante. Dans un mode de réalisation avantageux, le vecteur de déplacement est déterminé à partir de plusieurs vecteurs de décalage, préférentiellement des vecteurs de décalage adjacents.

Si le motif de simulation 4 est à l'intérieur du motif à réaliser 1, le calculateur détermine que le motif de travail 2 doit avoir une ou plusieurs dimensions augmentées afin de se rapprocher du motif à réaliser 1. L'enveloppe externe est déplacée ce qui forme le nouveau motif de travail 2 qui tient compte des informations sur le décalage qui proviennent des vecteurs de décalage V_{S}.

Dans l'exemple illustré à la figure 5, les différents côtés du motif à réaliser 1 sont traités différemment. Certains côtés sont découpés en plusieurs morceaux et sont traitées indépendamment. Il peut alors résulter qu'un côté initialement droit soit transformé en un côté avec des créneaux. D'autres côtés présentent plusieurs zones de repères mais le traitement est configuré de manière à ce que le côté reste plan. Dans d'autre configuration, une seule zone repère peut est disposée sur le côté afin de définir le déplacement de tout le côté.

Ainsi, à chaque itération, un nouveau motif 2 de travail est formé en partant avantageusement du motif à réaliser 1 et en déplaçant au moins une partie de l'enveloppe externe du motif à réaliser 1 en fonction du jeu de vecteurs de déplacement V_{D}. Le motif de travail 2 est le motif qui subit l'étape de fracturation, la forme du motif de travail peut se différentier notablement de la forme du motif à réaliser 1 pour tenir compte des effets de proximité qui ont été évalués dans les itérations précédentes. Le motif de travail 2 est décrit par son contour et sa forme doit avantageusement anticiper les dégradations opérées notamment par les effets de proximité.

Les conditions spécifiques de déplacement de l'enveloppe externe du motif à réaliser 1 pour former le motif de travail 2 peuvent être réalisées par tout algorithme adapté. Par exemple, les conditions spécifiques de déplacement peuvent mettre en œuvre un correcteur de type PID pour Proportionnel - Intégral - Dérivé. Il est également possible d'utiliser un autre type de correction.

Dans un mode de réalisation préférentiel, la transformation du motif à réaliser 1 est configurée de sorte que le parallélisme entre les côtés du motif de travail 2 et les côtés du motif à réaliser 1 soit conservé.

A chaque itération, le motif de travail 2 est généré en fonction des conditions détectées lors de la précédente itération. Comme le motif de travail 2 évolue à chaque itération, les conditions de fracturation évoluent. A chaque itération, le jeu de dessins élémentaires 3 est modifié. Dans l'exemple de la figure 5, le jeu initial de trois dessins élémentaires est transformé en un jeu de sept dessins élémentaires 3a - 3g (figure 5).

Dans un mode de réalisation particulier, la fracturation en un jeu de dessins élémentaires 3 tient compte des conditions existantes sur le jeu de dessins élémentaires 3 de l'itération précédente. A titre d'exemple, le procédé peut être configuré de manière à ce que la variation du nombre de dessins élémentaires soit inférieure à 40% de sorte que les variations à venir sur les conditions d'insolation ne soient pas trop modifiées. Cette condition permet de faciliter la convergence du procédé.

La nouvelle fracturation S3 du motif de travail 2 se traduit par la définition d'un nouveau jeu de dessins élémentaires 3. Ce nouveau jeu de dessins élémentaires 3 comporte avantageusement des dessins élémentaires 3 inchangés, des dessins élémentaires déplacés spatialement mais inchangés dans la forme, des dessins élémentaires qui ont subi un changement de forme. Il est également possible d'avoir la disparition d'un dessin élémentaire 3 du jeu précédent et/ou la création d'un nouveau dessin élémentaire 3.

Dans l'exemple particulier illustré à la figure 5, le motif de travail 2 a été modifié au moyen des vecteurs de déplacement V_{D} en comparaison du motif de travail 2 de l'itération précédente. Comme la forme de l'enveloppe générale a changé, les conditions de l'étape de fracturation ont changé. La forme générale du motif 3a est globalement inchangée. Le motif initialement rectangulaire a été modifié dans une de ses dimensions. En revanche, le motif 3b a été décomposé en deux motifs distincts 3b et 3d afin de tenir compte du décroché réalisé pour limiter l'étendu de l'arrondissement du coin intérieur entre les motifs 3a et 3b de l'itération précédente.

De la même manière, le motif 3c a été décomposé entre quatre motifs 3c, 3e, 3f et 3g. Les motifs 3e et 3f permettent de limiter les effets d'arrondissement des coins extérieurs du motif 3c initial.

Comme un nouveau jeu de dessins élémentaires 3 est formé, il y a association d'un nouveau jeu de conditions d'insolation pour modéliser le nouveau motif de travail 2.

Comme précédemment, le jeu de conditions d'insolation est utilisé pour former un motif de simulation 4 comme cela est illustré à la figure 6. Le motif de simulation 4 est ensuite comparé au seuil pour déterminer si les dessins élémentaires sont considérés comme aboutis ou non. La modification du motif de travail 2 est réalisée sur la forme de son enveloppe externe de manière à compenser les écarts observés lors de l'itération précédente. Dans l'exemple illustré, les écarts importants détectés lors de l'itération précédente ont été quasiment corrigés. L'arrondissement excessif du coin concave a été éliminé en réduisant la hauteur du dessin élémentaire 3b par rapport à la hauteur du dessin élémentaire 3d sans que cela induise une variation notable dans l'épaisseur du motif de simulation.

De cette manière, entre deux itérations successives au moins une partie des dessins élémentaires 3 est modifiée en tenant compte des informations de l'itération précédente et les modifications sont réalisées successivement sur l'enveloppe externe du motif de travail pour se rapprocher du motif à réaliser 1 ce qui permet de faciliter la convergence du procédé.

Là encore à la fin de la nouvelle itération, si l'écart au motif à réaliser 1 est inférieur au seuil, le motif de simulation 4 est considéré comme proche du motif à réaliser 1 et les conditions d'insolation peuvent être employées pour former le motif 1 final sur la couche à irradier.

Ces étapes du procédé sont répétées tant que l'écart entre le motif de simulation 4 et le motif à réaliser 1 est supérieur au seuil.

Un fois le seuil atteint, les informations sur le motif de travail 2, les informations sur les dessins élémentaires 3 et/ou les informations sur les conditions d'irradiation sont envoyées à un dispositif de traitement. Le dispositif de traitement est utilisé ensuite pour former le motif à réaliser 1 sur un substrat.

Le procédé peut être mis en œuvre par tout calculateur adapté. Il est possible de réaliser le procédé à partir de jeux d'instructions enregistrés dans une mémoire configurée pour être lue par un ordinateur.

Dans un mode de réalisation particulier, les conditions de fracturation appliquées lors de l'étape S3 sont différentes des conditions de fracturation appliquées par l'équipement produisant le rayonnement électronique.

Dans ce cas de figure, la comparaison entre le motif de simulation 4 et le motif à réaliser 1 est inférieure au seuil. Le motif de travail 2 et les dessins élémentaires qui en résultent sont représentatifs du motif à réaliser 1. Une nouvelle fracturation est cependant réalisée.

Dans cette nouvelle fracturation, le motif de travail 2 est identique ou sensiblement identique à celui validé. Le motif de travail 2 est fracturé avec de nouvelles conditions de fracturations qui peuvent définir un nouveau jeu de dessins élémentaires. Les conditions de fracturation étant différentes, il est possible que le résultat soit moins pertinent que ce qui avait été obtenu précédemment. Avec cette nouvelle fracturation, un nouveau jeu de conditions d'insolation peut être associé au nouveau jeu de motifs élémentaires. Ces informations peuvent être envoyées à l'équipement produisant le rayonnement électronique pour former le motif à réaliser 1, par exemple en insolant une résine.

Ce mode de réalisation est particulièrement avantageux lorsque les conditions de fracturation appliquées par le dispositif de production du rayonnement électromagnétique sont très limitatives dans le choix des formes des motifs élémentaires. Dans ce cas de figure, des conditions plus pratiques sont appliquées dans les boucles d'itération ce qui permet de former un motif de travail 2 dans un minimum de temps. Ensuite, une fois le motif de travail formé, ce dernier peut être légèrement dégradé en appliquant des conditions de fracturation plus strictes. L'utilisation de deux conditions différentes de fracturation est particulièrement intéressant lorsque les différences sont essentiellement liées à des contraintes de découpage géométrique des motifs. Dans ce cas, les modifications réalisées sur le motif de travail durant la partie itérative ont peu ou pas d'influence sur le résultat final. La forme finale du motif de travail 2 est toujours représentative du motif à réaliser 1. Il n'y a que le découpage final du motif de travail qui change avec un faible effet sur la forme du motif final. Cette particularité permet de gagner en temps de calcul.

De manière avantageuse, les deux conditions de fracturation sont configurées de manière à ce que les tailles des motifs élémentaires soient sensiblement égales, c'est-à-dire que les variations en surface sont inférieures à 50%. De manière également avantageuse, les deux conditions de fracturation sont configurées de manière à ce que les formes générales des dessins soient conservées.

Dans un autre mode de réalisation, le nombre d'itérations peut être limité à un seuil maximal. De cette manière, si le procédé n'est pas en mesure de fournir les conditions permettant l'obtention d'un motif de travail pertinent, le procédé est arrêté lorsque le seuil maximal est atteint. L'utilisation d'un seuil maximal permet d'éviter que le procédé tourne durant des durées importantes par exemple si la forme du motif à réaliser ne permet pas la convergence du procédé.

Dans un mode de réalisation particulier qui peut être combiné avec les modes précédents, l'algorithme de détermination des doses électroniques à appliquer utilise un modèle de diffusion des électrons dans la matière qui présente une composante courte portée et plusieurs composantes moyennes et longues portées. Il est avantageux d'utiliser certains de ces paramètres du modèle de diffusion pour définir des caractéristiques des dessins élémentaires ou des zones de référence.

Si la composante courte portée est modélisée par une répartition gaussienne des électrons avec un écart type appelé A, il est avantageux de s'assurer que les dimensions du motif à réaliser 1 sont plus grandes que l'écart-type. Si plusieurs motifs distincts sont à réaliser, il faut analyser chaque motif à réaliser 1.

De manière encore plus avantageuse, il est possible de définir que le vecteur de déplacement est choisi de manière à avoir une norme inférieure ou égale à la moitié de l'écart-type de la répartition gaussienne pour chaque itération. Cette précaution permet de faciliter la convergence.

Dans un cas particulier, le modèle de diffusion prévoit que les composantes de moyennes et longues portées sont au nombre de N et sont représentées chacune par des gaussiennes appelées B_{X}, avec X variant de 1 à N et représentant l'ordre de la composante. La composante de rang 1 est la composante se rapprochant le plus de la composante courte portée. Il est avantageux de s'assurer que les conditions de fracturation sont choisies pour que les dimensions des motifs élémentaires soient cinq fois plus petites que l'écart type de la composante de rang 1 (composante de moyenne portée de rang 1). Cette précaution permet également de faciliter la convergence.

De manière particulièrement avantageuse, le nombre de dessins élémentaires 3 n'est pas modifié de plus de 30% entre deux itérations successives afin de faciliter la convergence du procédé.

De manière particulièrement avantageuse, la surface de chacun des dessins élémentaires 3 n'est pas modifiée de plus de 30% entre deux itérations successives afin de faciliter la convergence du procédé.

Il est particulièrement avantageux de limiter la modification des caractéristiques du dessin intermédiaire 3 entre deux itérations car les différents dessins élémentaires 3 servent à définir les conditions d'insolation à un ou plusieurs rayonnements électroniques. Modifier fortement plusieurs paramètres peut entrainer une augmentation forte de l'écart entre le motif à réaliser 1 et celui proposé par le procédé. La quasi-conservation des caractéristiques initiales des dessins élémentaires 3 permet de réduire les risques de divergence du procédé de génération de données pour la fabrication de motifs.

Dans un mode de réalisation particulièrement avantageux, les dessins élémentaires 3 ne se chevauchent pas de manière à éviter que certaines zones soient irradiées plusieurs fois. Cette précaution permet de réduire les artefacts d'écriture liés à au moins une double irradiation forte d'une même région de la résine.

Dans un mode de réalisation particulier, la dose d'affectée à un motif élémentaire est calculée une seule fois et ce résultat peut être utilisé pour plusieurs jeux de dessins élémentaires successifs, voire pour tous les jeux de dessins élémentaires. Dans une variante de réalisation, la dose affectée à un motif élémentaire est calculée à chaque fois pour tenir compte des évolutions réalisées à chaque itération.

Par rapport aux procédés de l'art antérieur, le procédé permet de fournir une solution de correction pour les motifs ayant des formes complexes. Dans le procédé, la fracturation est réalisée plus tard ce qui permet d'assurer la cohérence de l'ensemble des dessins élémentaires lorsqu'elle est recherchée, c'est-à-dire une absence de recouvrement entre les motifs. Cette cohérence assure un rendu plus fidèle de motif de simulation et une meilleure qualité de fracturation, par exemple en limitant le nombre de dessins élémentaires.

A titre d'exemple, en comparaison d'un procédé selon le document US 6,107,207, le procédé illustré permet de réduire le nombre de shots ce qui augmente la rapidité d'insolation.

En comparaison du procédé selon le document FR 2959026, le procédé illustré permet de tenir compte des effets de proximités introduits par les différentes modifications opérées sur les dessins élémentaires lors des différentes itérations.

Le procédé est particulièrement avantageux pour la transformation des motifs à réaliser complexes. En effet, les étapes de fracturation sont associées à une étape de simulation et une étape de comparaison au motif à réaliser de manière à définir les écarts. Le processus itératif permet de corriger les imperfections liées aux actions correctives réalisées sur les différents motifs élémentaires en prenant en compte les effets de proximité qui existe entre toutes les doses rayonnées. En comparaison, dans l'art antérieur, la fracturation est réalisée une fois pour toute en début de procédé.

## Revendications

1. Procédé de génération de données relatives à l'écriture d'un motif par rayonnement électronique, le procédé étant mis en oeuvre par un calculateur, le procédé étant **caractérisé en ce qu'**il comporte successivement
- S1) Fournir un motif à réaliser (1) sur un substrat,
- S2) Former un motif de travail (2), de manière avantageuse correspondant exactement au motif à réaliser, à partir du motif à réaliser (1), le motif de travail (2) comportant une seule enveloppe externe,
- S3) Fracturer le motif de travail (2) en un jeu de dessins élémentaires (3) comportant une pluralité de dessins élémentaires ayant chacun une seule enveloppe externe, et définir un jeu de conditions d'insolation pour chaque dessin élémentaire (3),
- S4) Comparer le motif à réaliser (1) avec un motif de simulation (4) représentant les jeux de conditions d'insolation des dessins élémentaires (3) pour discriminer un motif de simulation (4) représentatif du motif à réaliser (1) et un motif de simulation (4) non représentatif du motif à réaliser (1)
procédé dans lequel si le motif de simulation (4) est non représentatif du motif à réaliser (1), il comporte :
- S7) Déterminer au moins un vecteur de décalage entre au moins une partie de l'enveloppe externe du motif à réaliser (1) et une partie correspondante de l'enveloppe externe du motif de simulation (4),
- S8) Déplacer au moins une partie de l'enveloppe externe du motif de travail (2) ou du motif à réaliser (1) selon un vecteur de déplacement déterminé au moins à partir du vecteur de décalage correspondant pour former un nouveau motif de travail (2),
- Réaliser une nouvelle itération des étapes S3) et S4).

2. Procédé de génération selon la revendication 1, **caractérisé en ce que** lors de la fracturation (S3), le premier jeu de dessins élémentaires (3) est configuré pour éviter un recouvrement entre deux dessins élémentaires adjacents (3).

3. Procédé de génération selon l'une des revendications 1 et 2, dans lequel lors de l'étape de fracturation (S3), les positions d'une partie des dessins élémentaires (3) sont identiques aux positions occupées par une partie des dessins élémentaires (3) de l'itération précédente.

4. Procédé de génération selon l'une quelconque des revendications 1 à 3, dans lequel lors de l'étape de fracturation (S3), les formes et les surfaces d'une partie des dessins élémentaires (3) sont identiques aux formes et aux surfaces d'une partie des dessins élémentaires (3) de l'itération précédente.

5. Procédé de génération selon l'une quelconque des revendications 1 à 4, dans lequel le rapport entre le nombre de dessins élémentaires (3) formant le jeu de dessins élémentaires (3) et le nombre de dessins élémentaires (3) formant le jeu de dessins élémentaires (3) lors de l'étape de fracturation de l'itération précédente est compris entre 0,8 et 1,2.

6. Procédé de génération selon l'une quelconque des revendications 1 à 5, dans lequel après la comparaison (S6), le motif de travail (4) est modifié pour se rapprocher de la forme du motif à réaliser (1).

7. Procédé d'écriture d'un motif sur un substrat par rayonnement électronique **caractérisé en ce qu'**il comporte :
- utiliser le procédé de génération selon l'une quelconque des revendications 1 à 5,
- transmettre les jeux de conditions d'insolation de la dernière itération à un circuit de commande d'un canon à électrons.

## Patentansprüche

1. Verfahren zur Erzeugung von Daten im Zusammenhang mit dem Schreiben eines Motivs durch elektronische Strahlung, wobei das Verfahren durch einen Rechner eingesetzt wird, wobei das Verfahren **dadurch gekennzeichnet ist, dass** es nacheinander umfasst:
- S1) Bereitstellen eines herzustellenden Motivs (1) auf einem Substrat,
- S2) Bereitstellen eines Arbeitsmotivs (2), das vorteilhafterweise exakt dem herzustellenden Motiv entspricht, auf Basis des herzustellenden Motivs (1), wobei das Arbeitsmotiv (2) nur eine äußere Hülle umfasst,
- S3) Zerlegen des Arbeitsmotivs (2) in eine Gruppe von elementaren Mustern (3), umfassend eine Vielzahl von elementaren Mustern, die jeweils eine äußere Hülle haben, und Definieren einer Gruppe von Bestrahlungsbedingungen für jedes elementare Muster (3),
- S4) Vergleichen des herzustellenden Motivs (1) mit einem Simulationsmotiv (4), das die Gruppen von Bestrahlungsbedingungen der elementaren Muster (3) darstellt, um ein Simulationsmotiv (4), das für das herzustellende Motiv (1) repräsentativ ist, und ein Simulationsmotiv (4), das nicht für das herzustellende Motiv (1) repräsentativ ist, zu unterscheiden,
wobei das Verfahren, wenn das Simulationsmotiv (4) nicht für das herzustellende Motiv (1) repräsentativ ist, umfasst:
- S7) Bestimmen mindestens eines Abweichungsvektors zwischen mindestens einem Teil der äußeren Hülle des herzustellenden Motivs (1) und einem entsprechenden Teil der äußeren Hülle des Simulationsmotivs (4),
- S8) Verlagern mindestens eines Teils der äußeren Hülle des Arbeitsmotivs (2) oder des herzustellenden Motivs (1) gemäß einem Verlagerungsvektors, der auf Basis des entsprechenden Abweichungsvektors bestimmt wurde, um ein neues Arbeitsmotiv (2) zu bilden,
- Durchführen einer neuerlichen Iteration der Schritte S3) und S4).

2. Erzeugungsverfahren nach Anspruch 1, **dadurch gekennzeichnet, dass** bei der Zerlegung (S3) die erste Gruppe von elementaren Mustern (3) konfiguriert ist, um eine Überdeckung zwischen zwei benachbarten elementaren Mustern (3) zu vermeiden.

3. Erzeugungsverfahren nach einem der Ansprüche 1 und 2, bei dem während des Zerlegungsschritts (S3) die Positionen eines Teils der elementaren Muster (3) mit den Positionen identisch sind, die von einem Teil der elementaren Muster (3) der vorhergehenden Iteration eingenommen sind.

4. Erzeugungsverfahren nach einem der Ansprüche 1 bis 3, bei dem während des Zerlegungsschritts (S3) die Formen und die Flächen eines Teils der elementaren Muster (3) mit den Formen und Flächen eines Teils der elementaren Muster (3) der vorhergehenden Iteration identisch sind.

5. Erzeugungsverfahren nach einem der Ansprüche 1 bis 4, bei dem das Verhältnis zwischen der Anzahl von elementaren Mustern (3), die die Gruppe von elementaren Mustern (3) bilden, und der Anzahl von elementaren Mustern (3), die die Gruppe von elementaren Mustern (3) während des Zerlegungsschritts der vorhergehenden Iteration bilden, zwischen 0,8 und 1, 2 beträgt.

6. Erzeugungsverfahren nach einem der Ansprüche 1 bis 5, bei dem nach dem Vergleichen (S6) das Arbeitsmotiv (4) verändert wird, um sich der Form des herzustellenden Motivs (1) anzunähern.

7. Verfahren zum Schreiben eines Motivs auf ein Substrat durch elektronische Strahlung, **dadurch gekennzeichnet, dass** es umfasst:
- Verwendung des Erzeugungsverfahrens nach einem der Ansprüche 1 bis 5,
- Übertragung der Gruppen von Bestrahlungsbedingungen der letzten Iteration auf eine Steuerschaltung einer Elektronenkanone.

## Claims

1. Method of generating data relative to the writing of a pattern by electronic radiation, the method being performed by a computer, the method being **characterized in that** it successively comprises:
- S1) Providing a pattern to be formed (1) on a substrate,
- S2) Forming a work pattern (2), advantageously exactly corresponding to the pattern to be formed, from the pattern to be formed (1), the work pattern (2) comprising a single external envelope,
- S3) Breaking down the work pattern (2) into a set of elementary outlines (3) comprising a plurality of elementary outlines each having a single external envelope, and defining a set of insolation conditions for each elementary outline (3),
- S4) Comparing the pattern to be formed (1) with a simulation pattern (4) representing the sets of insolation conditions for the elementary outlines (3) to discriminate a simulation pattern (4) representative of the pattern to be formed (1) from a simulation pattern (4) which is not representative of the pattern to be formed (1),
method wherein, if the simulation pattern (4) is not representative of the pattern to be formed (1), the method comprises:
- S7) Determining at least one shift vector between at least a portion of the external envelope of the pattern to be formed (1) and a corresponding portion of the external envelope of the simulation pattern (4),
- S8) Displacing at least a portion of the external envelope of the work pattern (2) or of the pattern to be formed (1) according to a displacement vector determined at least from the corresponding shift vector to form a new work pattern (2),
- Carrying out a new iteration of steps S3) and S4).

2. Generation method according to claim 1, **characterized in that** during the breaking down (S3), the first set of elementary outlines (3) is configured to avoid an overlapping between two adjacent elementary outlines (3).

3. Generation method according to any of claims 1 and 2, wherein during the breakdown step (S3), the positions of part of the elementary outlines (3) are identical to the positions occupied by part of the elementary outlines (3) of the previous iteration.

4. Generation method according to any of claims 1 to 3, wherein during the breakdown step (S3), the shapes and the surfaces of part of the elementary outlines (3) are identical to the shapes and to the surfaces of part of the elementary outlines (3) of the previous iteration.

5. Generation method according to any of claims 1 to 4, wherein the ratio of the number of elementary outlines (3) forming the set of elementary outlines (3) to the number of elementary outlines (3) forming the set of elementary outlines (3) during the breakdown step of the previous iteration is in the range from 0.8 to 1.2.

6. Generation method according to any of claims 1 to 5, wherein after the comparison (S6), the work pattern (4) is modified to becomes closer to the shape of the pattern to be formed (1).

7. Method of writing a pattern on a substrate by electronic radiation, **characterized in that** it comprises:
- using the generation method of any of claims 1 to 5,
- transmitting the sets of insolation conditions of the last iteration to an electron gun control circuit.
